# EUROPÄISCHE PATENTANMELDUNG

(11) **EP 1 286 266 A2**
(43) Veröffentlichungstag der Anmeldung: **26.02.2003**
(21) Anmeldenummer: 02015866.3
(22) Anmeldetag: 16.07.2002
(51) Int. Cl.: G06F 11/16

(54) **Vorrichtung und Verfahren zur Auswertung von mehreren Ergebnissen aus redundanten Berechnungen**

(30) Priorität: 26.07.2001 DE 10136622
(71) Anmelder: SIEMENS AKTIENGESELLSCHAFT, 80333 München (DE)
(72) Erfinder: De Wille, Eberhard, 92287 Schmidmühlen (DE); Kucera, Markus, Dr., 93059 Regensburg (DE)

(57) **Zusammenfassung**

Die Erfindung betrifft eine Vorrichtung zur Auswertung von mehreren Ergebnissen (A, B) aus redundanten Berechnungen mit einem Gültigkeitsausgang (VALID) und einem Datenausgang (DATA). Die Vorrichtung weist mehrere erste Vergleichereinrichtungen (XOR1, XOR2) auf, an deren jeweiligen Eingängen die mehreren Ergebnisse (A, B) angelegt sind. An einem Ausgang von jeder ersten Vergleichereinrichtung (XOR1, XOR2) liegt ein erstes Vergleichsergebnis an, das jeweils angibt, ob die mehreren Ergebnisse (A, B) unterschiedlich sind. Der Datenausgang (DATA) ist mit einem der Ausgänge der ersten Vergleichereinrichtungen (XOR1, XOR2) verbunden. Jeder der Ausgänge der ersten Vergleichereinrichtungen (XOR1, XOR2) ist jeweils mit einem Eingang von mehreren zweiten Vergleichereinrichtungen (XOR1', XOR2') verbunden. An einem Ausgang von jeder der zweiten Vergleichereinrichtungen liegt ein zweites Vergleichsergebnis an, das jeweils angibt, ob die mehreren ersten Vergleichsergebnisse unterschiedlich sind. Die Ausgänge der zweiten Vergleichereinrichtungen (XOR1', XOR2') sind jeweils mit einer Schalteinrichtung verbunden, wobei die Schalteinrichtung mit dem Gültigkeitsausgang (VALID) verbunden ist, um ein Signal auszugeben, das angibt, dass die mehreren zweiten Vergleichsergebnisse identisch sind.

## Beschreibung

Die Erfindung betrifft ein Verfahren und eine Vorrichtung zur Auswertung von mehreren Ergebnissen aus redundanten Berechnungen. Die Erfindung betrifft insbesondere Vorrichtungen zum Einsatz in sicherheitskritischen Systemen bei der Zusammenführung bzw. Auswahl von redundant berechneten Werten.

Bei sicherheitskritischen Systemen werden häufig Berechungen redundant durchgeführt. Bei Fehlerfreiheit der Systeme ergeben die Berechnungen bei gleichen Eingangswerten dann gleiche Ergebnisse. Das Überprüfen, ob die Ergebnisse identisch sind, wird in einer Auswertevorrichtung durchgeführt. Es muss jedoch sichergestellt werden, dass die Auswertevorrichtung, welche diese Aufgabe übernimmt, nicht durch mögliche eigene Fehler die angestrebte Zuverlässigkeit des Gesamtsystems verringert.

Es ist üblich, solche Auswertevorrichtungen auf ihre korrekte Funktion hin zu überprüfen. Zu diesem Zweck werden z.B. neben den zu vergleichenden Werten bestimmte Testmuster an die Einheiten übergeben und das Vergleichsergebnis mit dem vorher bekannten erwarteten Ergebnis überprüft. Diese Überprüfung findet jedoch außerhalb der Vergleichseinheit statt und erfordert einen zusätzlichen Schaltungsaufwand, z.B. zur Bereitstellung von Testmustern.

Es ist Aufgabe der vorliegenden Erfindung, eine eigensichere Auswertevorrichtung und ein Verfahren zur Auswertung von mehreren Ergebnissen aus redundanten Berechnungen zur Verfügung zu stellen, wobei beim Auftreten eines beliebigen Fehlers innerhalb der Auswertevorrichtung ein sicherer Zustand angenommen wird, d.h. ein Fehler nach außen signalisiert wird.

Die Aufgabe wird durch die Vorrichtung nach Anspruch 1 und das Verfahren nach Anspruch 7 gelöst. Weitere vorteilhafte Ausgestaltungen sind in den abhängigen Ansprüchen angegeben.

Erfindungsgemäß ist eine Vorrichtung zur Auswertung von mehreren Ergebnissen aus redundanten Berechnungen vorgesehen, die einen Gültigkeitsausgang aufweist. Die Vorrichtung weist mehrere erste Vergleichereinrichtungen auf, an deren jeweiligen Eingängen die mehreren Ergebnisse angelegt sind. An einem Ausgang jeder der ersten Vergleichereinrichtungen liegt jeweils ein erstes Vergleichsergebnis an. Jedes der ersten Vergleichsergebnisse gibt an, ob die mehreren redundant berechneten Ergebnisse unterschiedlich oder identisch sind. Jeder der Ausgänge der ersten Vergleichereinrichtung ist jeweils mit einem Eingang von mehreren zweiten Vergleichereinrichtungen verbunden. An einem Ausgang von jeder der zweiten Vergleichereinrichtungen liegt ein zweites Vergleichsergebnis an, das jeweils angibt, ob die mehreren ersten Vergleichsergebnisse identisch oder unterschiedlich sind. Die Ausgänge der zweiten Vergleichereinrichtungen sind jeweils mit einer Schalteinrichtung verbunden, wobei die Schalteinrichtung einen Ausgang aufweist, an dem ein Signal ausgegeben wird, das angibt, dass die mehreren zweiten Vergleichsergebnisse identisch sind.

Gemäß einem weiteren Aspekt der Erfindung ist ein Verfahren zur Auswertung von mehreren Ergebnissen aus redundanten Berechnungen vorgesehen. Zunächst werden die Ergebnisse aus den redundanten Berechnungen mehrfach miteinander verglichen, um mehrere erste Vergleichsergebnisse zu erhalten. Die Vergleichsergebnisse geben jeweils an, ob die mehreren Ergebnisse identisch oder unterschiedlich sind. Anschließend werden die ersten Vergleichsergebnisse miteinander mehrfach verglichen, und man erhält mehrere zweite Vergleichsergebnisse, die jeweils angeben, ob die mehreren ersten Vergleichsergebnisse identisch oder unterschiedlich sind. Wenn die mehreren zweiten Vergleichsergebnisse identisch sind, wird ein Gültigkeitssignal ausgegeben, das angibt, dass kein Fehler aufgetreten ist oder dass die redundant berechneten Ergebnisse identisch sind. Andernfalls gibt das Gültigkeitssignal an, dass ein Fehler aufgetreten ist.

Der Vorteil der beschriebenen Erfindung liegt darin, dass die Auswertevorrichtung selbst ihre Fehlerfreiheit überprüft und dadurch eine wesentlich einfachere Integration in bestehende Systeme ermöglicht, weil keine Testeinrichtungen für die Auswertevorrichtung implementiert werden müssen. Dies wird dadurch erreicht, dass mehrere erste Vergleichereinrichtungen und mehrere zweite Vergleichereinrichtungen vorgesehen sind. Die ersten Vergleichereinrichtungen dienen im wesentlichen dazu, zu erkennen, ob die Ergebnisse aus den redundanten Berechnungen identisch sind. Erkennen alle ersten Vergleichereinrichtungen, dass alle redundant berechneten Ergebnisse identisch sind, so geben sie identische Werte aus, die den mehreren zweiten Vergleichereinrichtungen zugeführt werden.

Die zweiten Vergleichereinrichtungen überprüfen nun mehrfach, ob jede der ersten Vergleichereinrichtungen in gleicher Weise erkannt hat, ob die anliegenden mehreren Ergebnisse aus den redundanten Berechnungen identisch sind oder unterschiedlich sind. Nur wenn alle ersten Vergleichereinrichtungen zu einem gleichen Ergebnis gekommen sind, bewirken die als fehlerfrei angenommenen zweiten Vergleichereinrichtungen über die Schalteinrichtung, dass an dem Gültigkeitsausgang ein Signal ausgegeben wird, mit dem die ersten Vergleichsergebnisse als gültig gekennzeichnet werden. Ein Fehler wird ebenfalls erkannt, wenn eine oder mehrere der zweiten Vergleichereinrichtungen fehlerbehaftet ist, da in diesem Fall die zweiten Vergleichsergebnisse verschieden sind. In diesem Fall legt die Schalteinrichtung an den Gültigkeitsausgang ein Gültigkeitssignal an, das einen Fehler signalisiert. Auf diese Weise kann eine Vorrichtung geschaffen werden, die einen Ausfall von mindestens einer der ersten und zweiten Vergleichereinrichtungen erkennt und an dem Gültigkeitsausgang ein entsprechendes Gültigkeitssignal anlegt.

Gemäß einer bevorzugten Ausführungsform ist vorgesehen, dass die Schalteinrichtung mehrere Schalter aufweist, die in Reihe geschaltet sind und die durch jeweils einen der Ausgänge der zweiten Vergleichereinrichtung gesteuert sind. Die Schalter werden geschlossen, wenn das jeweilige zweite Vergleichsergebnis angibt, dass die ersten Vergleichsergebnisse aus den ersten Vergleichereinrichtungen identisch sind. An einem Ende der in Reihe geschalteten Schalter ist eine Signalquelle angeschlossen, die auf den Gültigkeitsausgang der Vorrichtung durchgeschaltet wird, wenn alle Schalter geschlossen sind, d.h., wenn alle zweiten Vergleichsergebnisse signalisieren, dass die ersten Vergleichsergebnisse identisch sind. Vorzugsweise werden die Schalter als Transistoren ausgeführt.

Eine solche Schaltung hat den Vorteil, dass sie relativ ausfallsicher ist. Ist einer oder mehrere der Transistoren dauerhaft aufgrund eines Fehlers geöffnet, so liegt an dem Gültigkeitsausgang der Vorrichtung ein Signal an, das angibt, dass ein Fehler aufgetreten ist, d.h. die Signalquelle mit dem Gültigkeitssignal ist nicht auf den Gültigkeitsausgang durchgeschaltet. Ist einer der Transistoren dauerhaft geschlossen, so übernimmt der/die verbleibenden Transistor(en) mit den daran angeschlossenen zweiten Vergleichereinrichtungen wie zuvor die Funktion des Überprüfens, ob die ersten Vergleichsergebnisse der ersten Vergleichereinrichtungen identisch oder unterschiedlich sind. Somit ist die Verwendung einer solchen Schaltung vorteilhafter als die Verwendung z.B. einer UND-Schaltung, weil bei dieser z.B. ein Fehler auftreten kann, bei dem an den Gültigkeitsausgang der Vorrichtung ein Gültigkeitssignal angelegt wird, das die Fehlerfreiheit der Vorrichtung bedeutet.

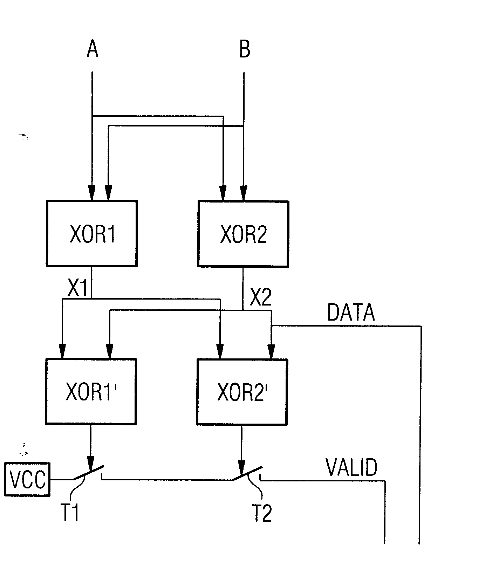

Die Erfindung wird im Folgenden anhand der beigefügten Zeichnung näher erläutert.

Die einzige Figur zeigt eine Auswertevorrichtung zur Auswertung von zwei Ergebnissen A, B aus redundanten Berechnungen. Die Auswertevorrichtung weist ein erstes Exklusiv-ODER-Gatter XOR1 und ein zweites Exklusiv-ODER-Gatter XOR2 mit jeweils zwei Eingängen auf. An den Eingängen des ersten Exklusiv-ODER-Gatters XOR1 und des zweiten Exklusiv-ODER-Gatters XOR2 sind jeweils die Ergebnisse aus den redundanten Berechnungen A, B angelegt.

Exklusiv-ODER-Gatter haben grundsätzlich die Funktion, Werte an ihren Eingängen auf Gleichheit zu überprüfen. Die Ergebnisse dieser Überprüfung stellen jeweils Einzelbits dar, wobei am Ausgang des Exklusiv-ODER-Gatters eine logische "0" ausgegeben wird, wenn die Eingangswerte gleich und eine logische "1" ausgegeben wird, wenn die Eingangswerte ungleich sind.

An dem Ausgang des ersten Exklusiv-ODER-Gatters XOR1 liegt ein erstes Vergleichsergebnis X1 an und an dem Ausgang des zweiten Exklusiv-ODER-Gatters XOR2 liegt ein zweites Vergleichsergebnis X2 an. Der Ausgang des zweiten Exklusiv-ODER-Gatters XOR2 ist mit dem Datenausgang DATA verbunden. Es ist ebenso möglich, den Datenausgang DATA mit dem Ausgang des ersten Exklusiv-ODER-Gatters XOR1 zu verbinden. Bei korrekter Funktion liegt an dem Datenausgang DATA eine logische "0" an, wenn die Ergebnisse aus den redundanten Berechnungen A, B gleich sind und eine logische "1", wenn die Ergebnisse A, B unterschiedlich sind.

Der Ausgang des ersten Exklusiv-ODER-Gatters XOR1 und der Ausgang des zweiten Exklusiv-ODER-Gatters XOR2 sind jeweils mit einem dritten Exklusiv-ODER-Gatter XOR1' und einem vierten Exklusiv-ODER-Gatter XOR2' verbunden. Der Ausgang der dritten Exklusiv-ODER-Schaltung XOR1' ist mit einem Steuereingang eines ersten Transistors T1 und der Ausgang der vierten Exklusiv-ODER-Schaltung XOR2' ist mit einem Steuereingang eines zweiten Transistors T2 verbunden. Der erste Transistor T1 und der zweite Transistor T2 sind in Reihe geschaltet. An einem Ende der Reihenschaltung ist eine Spannungsversorgung VCC angeschlossen, das andere Ende der Reihenschaltung stellt den Gültigkeitsausgang VALID der Auswertevorrichtung dar. Das Signal an dem Gültigkeitsausgang VALID gibt an, ob das an dem Datenausgang DATA anliegende Datum gültig ist oder nicht. Gültig ist es, wenn die Auswertevorrichtung fehlerfrei arbeitet und die Ergebnisse A, B die redundanten Berechnungen identisch sind.

Die Transistoren T1, T2 arbeiten als Schalter, die geschlossen werden, sobald an deren Steuereingängen eine logische "0" angelegt wird, d.h. wenn die zweiten Vergleichereinrichtungen gleiche erste Vergleichsergebnisse feststellen. Sind die Transistoren T1 und T2 geschlossen, wird der Spannungspegel der Spannungsversorgung VCC an den Gültigkeitsausgang VALID angelegt, wodurch signalisiert wird, dass das an den Datenausgang DATA anliegende Datum plausibel ist.

Der Zweck der Auswertevorrichtung ist einerseits, das an dem Datenausgang DATA anliegende Datum mit Hilfe des Gültigkeitsausgangs VALID zu plausibilisieren und andererseits eine ausreichende Eigensicherheit zur Verfügung zu stellen. Dazu werden die Einzelbits des ersten Exklusiv-ODER-Gatters XOR1 und des zweiten Exklusiv-ODER-Gatters XOR2 mittels zwei weiterer des dritten und des vierten Exklusiv-ODER-Gatters XOR1', XOR2' auf Gleichheit überprüft. Das dritte Exklusiv-ODER-Gatter XOR1' und das vierte Exklusiv-ODER-Gatter XOR2' sind am Ausgang mit je einem Transistor T1, T2 verbunden, der die Zuleitung eines Logikpegels, der dem Zustand "gültig" entspricht, zum Gültigkeitsausgang VALID der Auswertevorrichtung ermöglicht.

Mit Hilfe einer solchen Auswertevorrichtung kann jeder auftretende Erstfehler der Schaltung erkannt werden und diesen durch den Logikpegel, der dem Zustand "ungültig" entspricht, am Gültigkeitsausgang VALID der Auswertevorrichtung angezeigt werden. Liegt am Gültigkeitsausgang VALID ein "ungültig"-Signal an, so bedeutet dies für eine nachfolgende am Datenausgang DATA angeschlossene Schaltung, dass die anliegenden Daten fehlerbehaftet sein können. Aus diesem Grund ist es zum einen notwendig, mit mehr als einem Exklusiv-ODER-Gatter zum Vergleich der Eingangswerte zu arbeiten. Auf diese Weise werden die möglichen Erstfehler stuck at 0, stuck at 1 beim Eingangswertvergleich erkannt. Zum anderen ist es erforderlich, mit zwei weiteren Exklusiv-ODER-Gattern, dem dritten Exklusiv-ODER-Gatter XOR1' und dem vierten Exklusiv-ODER-Gatter XOR2' die Ergebnisse des Eingangswertvergleichs zu verschalten. Auf diese Weise werden die möglichen Erstfehler "stuck at 0", "stuck at 1" beim Ergebniswertvergleich toleriert. Somit ist es möglich, einen Fehler der Auswertevorrichtung zu erkennen, sobald ein wesentliches Element der Auswertevorrichtung ausfällt.

Die erfindungsgemäße Auswertevorrichtung ist nicht auf den Vergleich von zwei Ergebniswerten beschränkt. Durch eine Erhöhung der Zahl der Eingänge der ersten Vergleichereinrichtungen kann der Vergleich von einer beliebigen Anzahl von Ergebnissen vorgenommen werden. Ebenso kann die Fehlersicherheit der Auswertevorrichtung durch Verwenden einer größeren Zahl von ersten Vergleichereinrichtungen und/oder zweiten Vergleichereinrichtungen erhöht werden.

Die in der vorangehenden Beschreibung, den Ansprüchen und der Zeichnung offenbarten Merkmale der Erfindung können sowohl einzeln als auch in beliebiger Kombination zur Verwirklichung der Erfindung in ihren verschiedenen Ausführungsformen wesentlich sein.

## Patentansprüche

1. Vorrichtung zur Auswertung von mehreren Ergebnissen (A, B) aus redundanten Berechnungen mit einem Gültigkeitsausgang (VALID) und einem Datenausgang (DATA),
wobei die Vorrichtung mehrere erste Vergleichereinrichtungen (XOR1, XOR2) aufweist, an deren jeweiligen Eingängen die mehreren Ergebnisse (A, B) angelegt sind,
wobei an einem Ausgang von jeder ersten Vergleichereinrichtung (XOR1, XOR2) ein erstes Vergleichsergebnis (X1, X2) anliegt, das jeweils angibt, ob die mehreren Ergebnisse (A, B) unterschiedlich sind,
wobei der Datenausgang (DATA) mit einem der Ausgänge der ersten Vergleichereinrichtungen (XOR1, XOR2) verbunden ist,
**dadurch gekennzeichnet,**
**dass** jeder der Ausgänge der ersten Vergleichereinrichtungen (XOR1, XOR2) jeweils mit einem Eingang von mehreren zweiten Vergleichereinrichtungen (XOR1', XOR2') verbunden ist,
wobei an einem Ausgang von jeder zweiten Vergleichereinrichtung (XOR1', XOR2') ein zweites Vergleichsergebnis anliegt, das jeweils angibt, ob die mehreren ersten Vergleichsergebnisse unterschiedlich sind,
wobei die Ausgänge der zweiten Vergleichereinrichtungen (XOR1', XOR2') jeweils mit einer Schalteinrichtung verbunden sind,
wobei die Schalteinrichtung mit dem Gültigkeitsausgang (VALID) verbunden ist, um ein Signal an dem Gültigkeitsausgang (VALID) auszugeben, das angibt, dass die mehreren zweiten Vergleichsergebnisse identisch sind.

2. Vorrichtung nach Anspruch 1, **dadurch gekennzeichnet, dass** die ersten Vergleichereinrichtungen (XOR1, XOR2) und/oder die zweiten Vergleichereinrichtungen (XOR1', XOR2') als Exklusiv-ODER-Schaltungen ausgeführt sind.

3. Vorrichtung nach Anspruch 1 oder 2, **dadurch gekennzeichnet, dass** die Schalteinrichtung eine UND-Schaltung ist.

4. Vorrichtung nach Anspruch 1 oder 2, **dadurch gekennzeichnet,**
**dass** die Schalteinrichtung mehrere Schalter (T1, T2) aufweist, die in Reihe geschaltet sind und die durch jeweils einen der Ausgänge der zweiten Vergleichereinrichtungen (XOR1', XOR2') gesteuert sind, wobei der jeweilige Schalter (T1, T2) geschlossen wird, wenn das jeweilige zweite Vergleichsergebnis angibt,
**dass** die ersten Vergleichsergebnisse identisch sind, um ein Signal an den Gültigkeitsausgang (VALID) der Vorrichtung anzulegen, wenn alle Schalter (T1, T2) geschlossen sind.

5. Vorrichtung nach Anspruch 4, **dadurch gekennzeichnet, dass** zumindest einer der Schalter (T1, T2) einen Transistor (T1, T2) aufweist.

6. Vorrichtung nach einem der Ansprüche 1 bis 5, **dadurch gekennzeichnet, dass** die Vorrichtung zwei erste Vergleichereinrichtungen (XOR1, XOR2) und/oder zwei zweite Vergleichereinrichtungen (XOR1', XOR2') aufweist.

7. Verfahren zur Auswertung von mehreren Ergebnissen aus redundanten Berechnungen mit folgenden Schritten:
Mehrfaches Vergleichen der Ergebnisse, um mehrere erste Vergleichsergebnisse zu erhalten, die jeweils angeben, ob die mehreren Ergebnisse identisch oder unterschiedlich sind;
Mehrfaches Vergleichen der ersten Vergleichsergebnisse, um zweite Vergleichsergebnisse zu erhalten, die jeweils angeben, ob die mehreren ersten Vergleichsergebnisse identisch oder unterschiedlich sind und
Ausgeben eines Gültigkeitssignals, wenn die mehreren zweiten Vergleichsergebnisse identisch sind.
